# FASCICULE DE BREVET EUROPEEN

(11) **EP 3 443 365 B1**
(45) Date de publication et mention de la délivrance du brevet: **10.08.2022**
(21) Numéro de dépôt: 17717651.8
(22) Date de dépôt: 07.04.2017
(51) Int. Cl.: G01R 15/18

(54) **APPAREIL DE MESURE DE COURANTS ÉLECTRIQUES**
VORRICHTUNG ZUR MESSUNG VON ELEKTRISCHEN STRÖMEN
DEVICE FOR MEASURING ELECTRIC CURRENTS

(30) Priorité: 11.04.2016 FR 1653163
(43) Date de publication de la demande: 20.02.2019
(73) Titulaire: Schneider Electric Industries SAS, 92500 Rueil-Malmaison (FR)
(72) Inventeur: HOUBRE, Pascal, 38560 Jarrie (FR); BUFFAT, Sébastien, 38210 Tullins (FR)
(74) Mandataire: Lavoix
(86) Numéro de dépôt international: PCT/EP2017/058423
(87) Numéro de publication internationale: WO 2017/178378

(56) Documents cités:
- WO-A1-2013/001298
- DE-A1- 19 731 170
- US-A1- 2013 193 987

## Description

L'invention concerne un appareil de mesure de courants électriques circulant dans des conducteurs électriques.

On connaît des capteurs de courants électriques inductifs, dits capteurs de Rogowski, destinés à être placés autour d'un conducteur électrique, tel qu'un câble ou une ligne électrique, dans lequel circule un courant électrique alternatif que l'on souhaite mesurer. Un tel capteur comporte typiquement un solénoïde, disposé autour du conducteur électrique. Le courant qui circule dans le conducteur électrique génère un champ magnétique, qui à son tour génère, aux bornes de cet enroulement, une différence de potentiel électrique proportionnelle à l'intensité du courant électrique. On détermine alors la valeur d'intensité de ce dernier à partir de la différence de potentiel mesurée.

EP 1 596 206 A1 décrit un tel capteur de courant, dit de type Rogowski, dans lequel le solénoïde est obtenu en assemblant plusieurs bobines distinctes autour du conducteur électrique et en les connectant électriquement entre elles en série pour former un circuit de mesure. Ces bobines sont par exemple des bobines pré-enroulées, identiques entre elles, ce qui permet d'optimiser la réalisation industrielle du capteur à partir de composants standardisés.

Un inconvénient de ce capteur connu est qu'il ne donne pas entière satisfaction lorsqu'on souhaite mesurer des courants circulant dans plusieurs conducteurs électriques, par exemple au sein d'un système électrique polyphasé. Il est en effet nécessaire d'utiliser un capteur pour chaque conducteur électrique. La juxtaposition de ces capteurs provoque un encombrement important, proportionnel au nombre de conducteurs électriques devant faire l'objet d'une mesure, ce qui n'est pas acceptable dans certaines applications, notamment lorsque les conducteurs électriques sont proches les uns des autres.

Les dispositifs décrits dans les documents suivants sont également connus de DE-19731170-A1, WO-2013/001298-A1 et US-2013/0193987-A1 et présentent des inconvénients similaires.

C'est à ces inconvénients qu'entend plus particulièrement répondre l'invention, en proposant un appareil de mesure du courant incluant des capteurs de courant de type Rogowski pour un système électrique comportant plusieurs conducteurs électriques, cet appareil pouvant être réalisé avec une construction simplifiée et un encombrement réduit.

A cet effet, l'invention concerne un appareil de mesure de courants électriques, comprenant des premier et deuxième capteurs de courants de type Rogowski, chacun apte à mesurer un courant électrique alternatif dans des premier et deuxième conducteurs électriques, chacun des premier et deuxième capteurs comportant des bobines raccordées électriquement en série pour former, respectivement, des premier et deuxième circuits de mesure, chaque bobine s'étendant selon un axe longitudinal, les bobines d'un même capteur étant accolées entre elles de sorte à délimiter une zone centrale de ce capteur pour recevoir le conducteur électrique correspondant, les bobines d'un même capteur ayant leurs axes longitudinaux formant un contour polygonal fermé entourant cette zone centrale de ce capteur, dans lequel l'une des bobines est commune aux premier et deuxième capteurs, cette bobine étant raccordée électriquement aux premier et deuxième circuits de mesure, l'axe longitudinal de cette bobine appartenant aux premier et deuxième contours polygonaux.

Grâce à l'invention, du fait que l'une des bobines est commune aux premier et deuxième capteurs, l'encombrement de l'appareil de mesure se trouve réduit, puisqu'il comporte une bobine en moins par rapport au cas où on juxtapose des capteurs connus les uns à côté des autres. Le coût de réalisation d'un tel appareil de mesure est également réduit, puisqu'il nécessite une bobine en moins. Enfin, les inventeurs ont déterminé qu'un tel agencement des bobines permet d'obtenir une mesure du courant qui présente une fiabilité et une précision analogue et suffisantes par rapport à l'utilisation de deux capteurs connus distincts et juxtaposés.

Selon des aspects avantageux mais non obligatoires de l'invention, un tel appareil de mesure peut incorporer une ou plusieurs des caractéristiques suivantes, prises dans toute combinaison techniquement admissible :
- L'appareil comporte en outre un troisième capteur de courant de type Rogowski apte à mesurer un courant électrique dans un troisième conducteur électrique ce troisième capteur comportant des bobines raccordées électriquement en série pour former un quatrième circuit de mesure, ces bobines étant accolées entre elles de sorte à délimiter une zone centrale du troisième capteur pour recevoir le troisième conducteur électrique, les axes longitudinaux respectifs de ces bobines formant un troisième contour polygonal fermé qui entoure la zone centrale de ce capteur, l'une des bobines est commune aux deuxième et troisième capteurs, cette bobine étant raccordée électriquement aux deuxième et troisième circuits de mesure, l'axe longitudinal de cette bobine appartenant aux deuxième et troisième contours polygonaux.
- Les circuits de mesure des capteurs sont raccordés à une masse électrique commune de l'appareil de mesure.
- L'appareil comporte un support, sur lequel les bobines sont fixées et étant pourvu de pistes électriquement conductrices, les bobines étant raccordées électriquement entre elles au moyen des pistes pour former les circuits de mesure.
- Les contours polygonaux présentent une forme de quadrilatère, par exemple une forme carrée.
- Chaque capteur comporte quatre bobines, l'axe longitudinal de chaque bobine de ce capteur formant un côté du quadrilatère.
- Les contours polygonaux sont contenus dans un même plan géométrique essentiellement perpendiculaire aux conducteurs électriques.
- Chaque bobine comporte un enroulement ménagé autour d'une carcasse s'étendant le long de l'axe longitudinal de la bobine, au moins deux bobines de capteurs distincts et dont les axes longitudinaux sont confondus entre eux partagent une même carcasse s'étendant le long de cet axe, les enroulements respectifs de ces bobines étant ménagés autour de cette même carcasse.
- Au moins une bobine comporte une zone d'extrémité dans laquelle l'inductance de la bobine est augmentée par rapport au reste de la bobine.
- Les bobines de chaque capteur sont arrangées et connectées entre elles de sorte à présenter des sens de bobinage complémentaires, c'est-à-dire arrangés de sorte à tourner dans un même sens autour du conducteur électrique autour duquel le capteur correspondant est placé.

L'invention sera mieux comprise et d'autres avantages de celle-ci apparaîtront plus clairement à la lumière de la description qui va suivre, d'un mode de réalisation d'un appareil de mesure donnée uniquement à titre d'exemple et faite en référence aux dessins annexés dans lesquels :
- la figure 1 est une représentation schématique simplifiée, selon une vue de face, d'un ensemble de mesure selon l'état de la technique, comportant trois capteurs de courant de type Rogowski ;
- la figure 2 est une représentation schématique d'un circuit électrique illustrant la connexion des capteurs de courant de l'ensemble de la figure 1 ;
- la figure 3 est une représentation schématique, selon une vue en perspective, d'un appareil de mesure de courant conforme à un mode de réalisation de l'invention ;
- la figure 4 est une représentation schématique simplifiée, selon une vue de face, de l'appareil de la figure 3 ;
- la figure 5 est une représentation schématique d'un circuit électrique représentant la connexion des capteurs de courant de l'appareil des figures 3 et 4 ;
- la figure 6 est une représentation schématique d'une unité de traitement de données connectée aux capteurs de courant de l'ensemble de mesure de la figure 1 ;
- la figure 7 est une représentation schématique d'une unité de traitement de données connectée aux capteurs de courant de l'ensemble de mesure de la figure 2.

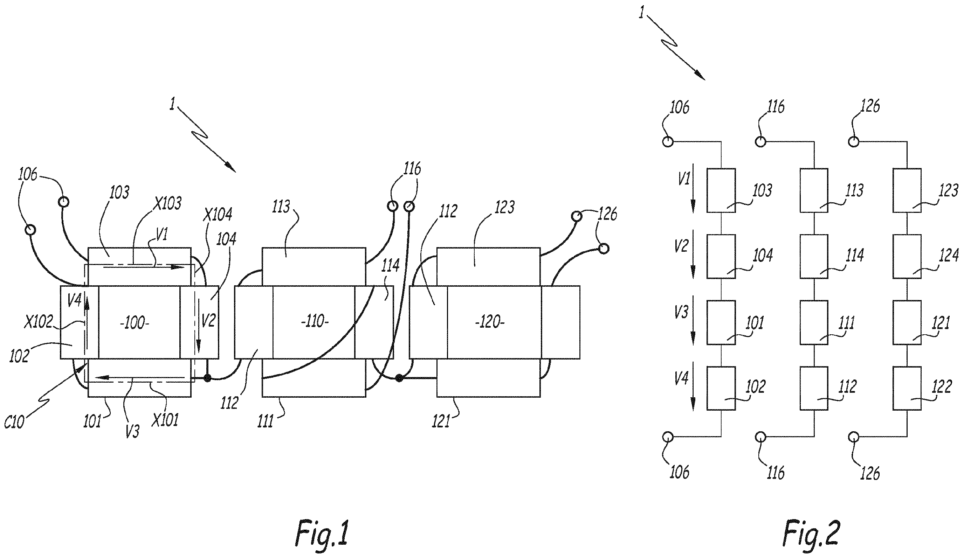

Les figures 1 et 2 représentent un ensemble 1 de mesure d'un courant électrique alternatif dans des conducteurs électriques 100, 110 et 120. Par exemple, les conducteurs 100, 110 et 120 sont des câbles électriques d'un système électrique triphasé. Chacun des conducteurs 100, 110 et 120 est parcouru par un courant électrique que l'on souhaite mesurer. Ce courant est par exemple un courant alternatif, dont les phases sont déphasées l'une par rapport à l'autre d'un angle de 120°.

L'ensemble 1 comporte trois capteurs de courant de type Rogowski 10, 11 et 12. Les capteurs 10, 11 et 12 sont ici identiques, de sorte que seul le capteur 10 est décrit en détail dans ce qui suit.

Le capteur 10 comporte des bobines 101, 102, 103 et 104 qui s'étendent chacune le long d'un axe longitudinal rectiligne, noté respectivement X101, X102, X103 et X104.

De façon connue, chaque bobine 101, 102, 103 et 104 comporte une carcasse, de préférence rigide, qui s'étend le long de l'axe longitudinal de cette bobine X101, X102, X103 et X104. Chaque bobine 101, 102, 103 et 104 comporte également un enroulement, ici d'un fil électriquement conducteur, autour de la carcasse, entre des extrémités de cette bobine. Les bobines 101, 102, 103 et 104 sont de préférence des bobines pré-enroulées.

Les bobines 101, 102, 103 et 104 sont disposées dans un même plan géométrique, ici perpendiculaire au conducteur 100, et sont agencées les unes par rapport aux autres de sorte à ce que leurs axes longitudinaux X101, X102, X103 et X104 respectifs forment un contour polygonal fermé C10. Ces bobines sont accolées les unes aux autres et délimitent une ouverture centrale 105 du capteur 10, au travers de laquelle passe le conducteur 100 lorsque le capteur 10 est en configuration montée. Ici, le contour C10 présente une forme carrée.

Les enroulements respectifs des bobines 101, 102, 103 et 104 sont raccordés électriquement en série, de sorte à former un circuit de mesure entre des bornes 106 du capteur 10, comme illustré à la figure 2.

Dans cette description, lorsque deux bobines sont dites être connectées électriquement entre elles, il faut comprendre que ce sont leurs enroulements électriques respectifs qui sont connectés électriquement entre eux.

De façon connue, lorsqu'un courant électrique circule le long du conducteur 100, cela engendre un champ magnétique autour de ce conducteur 100 et donc un flux magnétique au niveau de chaque bobine 101, 102, 103 et 104. En réponse, il apparaît des différences de potentiel électrique V1, V2, V3 et V4 entre des extrémités de l'enroulement de chaque bobine 101, 102, 103 et 104. Du fait que les bobines 101, 102, 103 et 104 sont connectées électriquement en série, les différences de potentiel V1, V2, V3 et V4 s'additionnent entre les bornes 106. La valeur du courant électrique qui circule dans le conducteur 100 est ensuite déterminée en fonction de la différence de potentiel électrique entre les bornes 106. Cette détermination est par exemple réalisée à l'aide d'une unité de traitement de données, raccordée aux bornes 106. Le fonctionnement des capteurs 11 et 12 est analogue à celui du capteur 10.

Un tel ensemble 1 présente cependant des inconvénients, notamment un encombrement important lorsque les conducteurs 100, 110 et 120 sont proches les uns des autres.

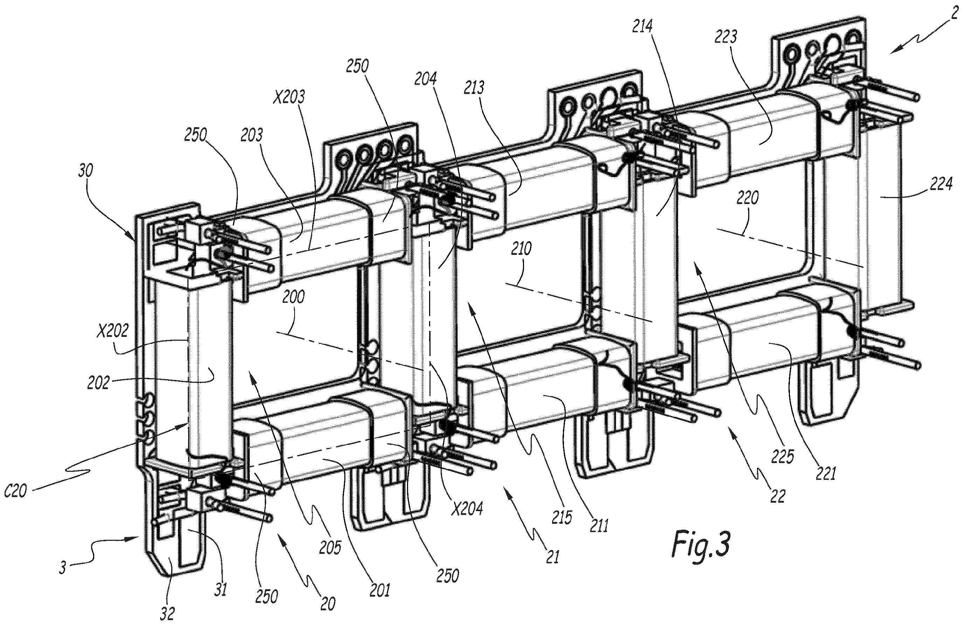

A cet effet, les figures 3, 4 et 5 représentent un appareil 2 de mesure selon l'invention, pour mesurer un courant électrique alternatif dans des conducteurs, respectivement, 200, 210 et 220 et qui remédie aux inconvénients précédents.

L'appareil 2 comporte des capteurs 20, 21, 22 de courant type Rogowski et un support 3, de préférence rigide, sur lequel les capteurs 20, 21 et 22 sont fixés. Chaque capteur 20, 21, 22 est configuré pour mesurer un courant électrique qui circule dans le conducteur électrique 200, 210, 220 correspondant. Les conducteurs électriques 200, 210, 220 sont par exemple identiques aux conducteurs 100, 110 et 120 et s'étendent ici parallèlement entre eux.

Le capteur 20 comporte ici quatre bobines 201, 202, 203 et 204. Chacune de ces bobines s'étend le long d'un axe longitudinal, noté respectivement X201, X202, X203 et X204. Ces bobines 201, 202, 203 et 204 sont accolées les unes aux autres, ici au niveau de leur extrémités, de manière à délimiter une ouverture centrale 205 du capteur 20 au travers de laquelle le conducteur 200 est reçu. Les axes longitudinaux X201, X202, X203 et X204 respectifs des bobines 201, 202, 203 et 204 forment un contour polygonal fermé C20 qui entoure l'ouverture centrale 205. Ce contour C20 s'étend dans un plan géométrique auquel le conducteur 200 est essentiellement perpendiculaire lorsqu'il est reçu dans l'ouverture centrale 205. Ainsi, en configuration montée du capteur 20 et de l'appareil 2, les bobines 201, 202, 203 et 204 entourent le conducteur 200.

Dans cet exemple, le contour C20 présente une forme carrée. Ici, les bobines 202 et 204 s'étendent parallèlement l'une à l'autre. Les bobines 203 et 201 s'étendent parallèlement l'une à l'autre perpendiculairement aux bobines 202 et 204. L'axe longitudinal X201, X202, X203 et X204 de chaque bobine du capteur 20 forme un côté du contour C20.

En variante, d'autres formes sont possibles, par exemple une forme de quadrilatère ou d'un polyèdre régulier. On préfèrera cependant un quadrilatère, qui garantit une meilleure compacité de l'appareil 2. Si d'autres formes sont utilisées, le nombre de bobines dans le capteur 20 est alors adapté en conséquence.

Dans cet exemple, l'axe longitudinal de chaque bobine du capteur 20 forme un coté du contour C20. En variante, deux bobines adjacentes d'un même capteur peuvent être alignées l'une avec l'autre et avoir leur axes confondus, de sorte qu'un même côté du contour C20 correspond à plusieurs bobines de ce capteur 20.

Chaque bobine comporte une carcasse s'étendant le long de l'axe géométrique de cette bobine. Chaque bobine comporte également un conducteur électrique enroulé autour de cette carcasse entre les extrémités de la bobine. Les bobines sont connectées électriquement entre elles deux à deux et en série. Par exemple, les bobines 201, 202, 203 et 204 sont identiques aux bobines 101, 102, 103 et 104.

Avantageusement, les bobines 201, 202, 203 et 204 peuvent comporter, au niveau d'une zone d'extrémité 250, une augmentation de leur valeur d'inductance. A titre d'exemple non limitatif, l'inductance d'une telle bobine dans la zone d'extrémité 250 est 20% supérieure ou, de préférence, 50% supérieure à l'inductance dans le reste de cette bobine en dehors de cette zone d'extrémité 250. A titre d'exemple, l'augmentation de la valeur d'inductance dans la zone d'extrémité 250 d'une bobine est réalisée en augmentant localement la densité de spires de l'enroulement du fil conducteur autour de la carcasse, par exemple en augmentant le nombre de spires par unité de longueur ou encore en augmentant le nombre de couches de spires. Un exemple de mise en œuvre d'une telle augmentation d'inductance est décrit dans EP 1 596 206 A1. Cela permet d'améliorer les propriétés de mesure de la bobine, pour compenser l'effet de la discontinuité magnétique au niveau des jonctions entre deux bobines adjacentes du capteur 20. Ceci est particulièrement utile si le contour C20 présente une forme de quadrilatère, car les spires situées aux extrémités des bobines adjacentes, par exemple les bobines 201 et 204, ne sont pas jointives.

Dans le présent exemple, au sein du capteur 20, seules les bobines 201 et 203 comportent de telles zones d'extrémité 250 dans lesquelles l'inductance est localement augmentée, comme illustré à la figure 3.

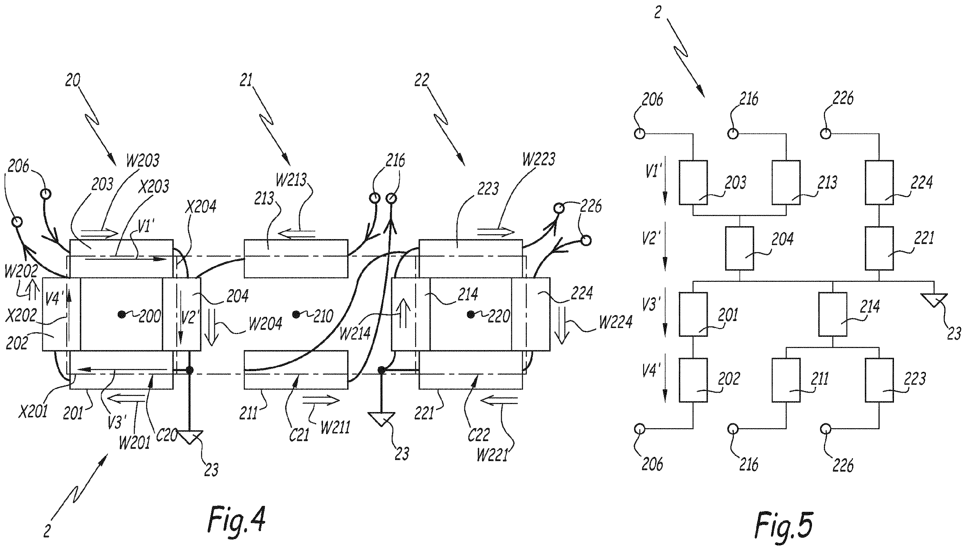

Dans cet exemple illustratif, les bobines 201, 202, 203 et 204 sont connectées électriquement en série entre des bornes de mesure 206 pour former un premier circuit de mesure du capteur 20, comme illustré à la figure 5. Plus précisément, ici, les bobines 203 et 204 sont connectées électriquement en série entre une des bornes 206 et un point milieu du circuit de mesure. Ce point milieu est raccordé à une masse électrique commune 23 dont le rôle est décrit plus en détail dans ce qui suit. De façon analogue, les bobines 201 et 202 sont connectées en série entre l'autre borne 206 et entre ce point milieu.

Les bornes 206 sont destinées à être raccordées électriquement à une unité de traitement de données 4, configurée pour déterminer la valeur du courant électrique circulant dans le conducteur 200 à partir de la différence de potentiel électrique mesurée entre ces bornes 206.

A la figure 4, les flèches W201, W202, W203 et W204 désignent, respectivement, le sens de bobinage des bobines 201, 202, 203 et 204. Le sens de bobinage d'une bobine, ou sens d'enroulement, désigne ici le sens dans lequel le fil conducteur formant cette bobine est enroulé autour de la carcasse lors de la fabrication de la bobine. En effet, ce fil conducteur est enrouler pour former des spires et présente, une fois enroulé autour de la carcasse, une trajectoire en forme d'hélice circulaire.

De préférence, les bobines de chaque capteur sont arrangées et connectées entre elles de sorte à présenter des sens complémentaires. En d'autres termes, les sens de bobinage des bobines d'un même capteur 20 sont arrangés de sorte à tourner dans un même sens autour du conducteur électrique 200 autour duquel le capteur 20 correspondant est placé. Par exemple, les sens d'enroulement de deux bobines adjacentes ne sont pas disposés tête-bêche.

Dans cet exemple, la bobine 201 est enroulée en partant depuis son extrémité qui est adjacente à la bobine 204 et en allant vers son extrémité qui est adjacente à la bobine 202. La bobine 202 est enroulée en partant depuis son extrémité qui est adjacente à la bobine 201 et en allant vers son extrémité qui est adjacente à la bobine 203, et ainsi de suite pour les bobines 203 et 204.

Dans cet exemple illustratif, le courant électrique de mesure circule entre les bornes de mesure 206 dans le même sens que le sens d'enroulement des bobines 201, 202, 203 et 204. Sur la figure 4, le sens de ce courant est représenté par les flèches dessinées au niveau des bornes de mesure 206. En variante, la polarité des bornes de mesure 206 peut être différente, le sens de circulation du courant de mesure étant alors inversé.

Le fonctionnement du capteur 20 est analogue à celui du capteur 10 précédemment décrit. Plus précisément, lorsqu'un courant électrique circule le long du conducteur électrique 200, il apparaît un flux magnétique le long des axes X201, X202, X203 et X204 des différentes bobines 201, 202, 203 et 204, causant l'apparition d'une différence de potentiel entre les extrémités des conducteurs de chacune de ces bobines. On note respectivement V1', V2', V3' et V4' les différences de potentiel électrique entre les extrémités des enroulements des bobines 201, 202, 203 et 204, comme illustré à la figure 5. De préférence, il est recommandé de raccorder le point milieu à la masse électrique commune 23 pour réaliser des mesures électriques différentielles.

Dans cet exemple, le support 3 comporte avantageusement des pistes 31 électriquement conductrices, par exemple ménagées sur une face du support 3. A titre illustratif et non limitatif, le support 3 comporte une plaque 30 de résine époxy ou de matière plastique, par exemple de type PCB, pour « printed circuit board » en langue anglaise. Les pistes 31 sont électriquement conductrices, par exemple réalisées en métal, et sont ici ménagées directement sur une face de la plaque 30.

Les bobines 201, 202, 203 et 204 sont ici fixées au support 3. Leurs extrémités sont connectées à ces pistes par l'intermédiaire de plots de connexion portés par des extrémités de ces bobines. Les pistes 31 sont préférentiellement conformées de manière à connecter entre elles les bobines du capteur comme expliqué précédemment.

En variante, les pistes 31 sont remplacées par des fils, qui peuvent être maintenus sur le support 3.

Le support 3 est ici pourvu de broches 32 de connexion de l'appareil 2. Par exemple, une partie des pistes 31 est reliée aux broches 32 pour les raccorder aux bornes 206. Ainsi, l'appareil 2 est facilement connectable à un dispositif par insertion des broches dans un connecteur correspondant. Ceci est particulièrement utile par exemple pour connecter l'appareil 2 à un dispositif comportant l'unité de traitement de données 4 précédemment mentionnée. En variante, l'unité de traitement de données 4 est fixée sur le support 3. Les connecteurs 32 peuvent être également utilisés pour fournir une alimentation électrique à l'unité de traitement de données 4 lorsque celle-ci est fixée sur le support 3. Les broches 32 peuvent être omises.

Les capteurs 21 et 22 fonctionnent de façon analogue au capteur 20.

Le capteur 21 comporte ici quatre bobines 211, 213, 214 et la bobine 204. Les bobines 211, 213 et 214 sont par exemple identiques, respectivement, aux bobines 201, 203 et 204. Les bobines 211, 213, 214 et 204 sont disposées les unes par rapport aux autres de façon à ce que leurs axes longitudinaux, non illustrés, forment un contour polygonal C21, analogue au contour C20, et qui est coplanaire avec le contour C20. Sur la figure 4, pour plus de visibilité, les bobines 211 et 213 sont illustrées séparées des autres bobines. Toutefois, en pratique, un tel espacement n'est pas souhaitable. Dans l'appareil 2, les bobines du capteur 21 sont attenantes les unes aux autres, comme illustré à la figure 3.

Les bobines 211, 213, 214 et 204 sont connectées électriquement en série entre des bornes de mesure 216, pour former un circuit de mesure du courant électrique du capteur 21. Ces bobines 211, 213, 214 et 204 définissent une ouverture centrale 215 du capteur 21, analogue à l'ouverture centrale 205, à travers de laquelle le conducteur 210 est reçu. Ainsi, tout ce qui a été dit en référence au capteur 20 s'applique au capteur 21.

Ici, la bobine 204 est commune au capteur 20 et au capteur 21. La bobine 204 est en outre raccordée électriquement à la fois au premier et au deuxième circuits de mesure, comme illustré à la figure 5. Plus précisément, les premier et deuxième circuits de mesure sont raccordés simultanément à la masse électrique commune 23. Cette masse commune 23 est reliée à un point milieu du deuxième circuit de mesure, de la même façon que celle décrite en référence au premier circuit de mesure.

Les bobines du capteur 21 sont connectées de façon analogue dans le deuxième circuit de mesure aux bobines du capteur 20. Par exemple, les bobines 213 et 204 sont connectées en série entre l'une des bornes 216 et entre le point milieu du deuxième circuit de mesure. Les bobines 211 et 214 sont connectées en série entre l'autre borne 216 du deuxième circuit de mesure et ce point milieu.

On note ici W211 le sens d'enroulement de la bobine 211 et W213 le sens d'enroulement de la bobine 213. Ce qui est décrit en référence au sens d'enroulement des bobines du capteur 20 s'applique également ici.

Du fait que la bobine 204 est commune aux capteurs 20 et 21, l'encombrement de l'appareil 2 est réduit, puisqu'il peut être réalisé avec une bobine en moins que dans l'ensemble 1 connu. Par rapport à l'ensemble de la figure 1, l'une des bobines 104 ou 112 est omise. L'appareil 2 présente ainsi un encombrement réduit ainsi qu'un coût de réalisation moindre, puisqu'il faut une bobine en moins pour le fabriquer.

Les tensions électriques mesurées entre les bornes 206 du premier circuit de mesure sont sensiblement les mêmes que celles que l'on mesurerait aux bornes 106 du circuit de mesure du capteur connu 10. Il en va de même pour les tensions mesurées aux bornes 216 du deuxième circuit de mesure du capteur 21 par rapport au capteur 11. Ainsi, une même unité de traitement de données 4 peut être utilisée indifféremment avec l'appareil 2 ou bien avec un ensemble 1 connu de l'état de la technique. De cette manière, l'appareil 2 peut être utilisé dans des installations existantes pourvues d'une unité de traitement de données, sans qu'il ne soit nécessaire de reprogrammer cette unité de traitement de données.

Dans cet exemple, l'appareil 2 comporte en outre un capteur 22 pour mesurer le courant électrique circulant le long du conducteur 220. Ce capteur 22 fonctionne de façon à analogue aux capteurs 20 et 21. Aussi, tout ce qui a été dit en référence à ces capteurs 20 et 21 s'applique ici au capteur 22.

Le capteur 22 comporte des bobines 221, 223, 224, par exemple identiques aux bobines 201, 203 et 204, et comporte également la bobine 214, qui est commune avec le capteur 21. Ceci permet, comme précédemment, d'augmenter la compacité et de réduire l'encombrement de l'appareil 2. Ces bobines 221, 223, 224 et 214 sont disposées de façon à ce que leurs axes longitudinaux, non illustrés, forment un contour polygonal C22, ici également coplanaire avec les contours C20 et C21 et présentant. De préférence, les contours C20, C21 et C22 présentent les mêmes dimensions et sont identiques entre eux. Le capteur 22 présente une ouverture centrale 225 délimitée par les bobines 221, 223, 224 et 214 et au travers de laquelle le conducteur 220 est reçu lorsque l'appareil est dans une configuration montée.

Les bobines 221, 223, 224 et 214 du capteur 22 sont connectées électriquement en série de façon à former un troisième circuit de mesure du capteur 22 entre des bornes 226. Tout ce qui a été décrit en référence aux bornes 206 s'applique également aux bornes 226.

Le troisième circuit de mesure est également raccordé électriquement à la masse électrique commune 23, d'une façon analogue à celle décrite en référence au circuit de mesure des capteurs 20 ou 21, comme illustré à la figure 5. Par exemple, la masse commune 23 est reliée à un point milieu du troisième circuit de mesure, de la même façon que celle décrite en référence au premier circuit de mesure. Les bobines du capteur 22 sont alors connectées de façon analogue à celle décrite en référence au capteur 21. Par exemple, les bobines 223 et 214 sont connectées en série entre l'une des bornes 226 et entre le point milieu du troisième circuit de mesure et les bobines 221 et 224 sont connectées en série entre l'autre borne 226 et ce point milieu.

On note ici W221, W222, W223 et W224 le sens d'enroulement des bobines 221, 222, 223 et 224, respectivement. Ce qui est décrit en référence au sens d'enroulement des bobines du capteur 20 s'applique également ici.

Avantageusement, lorsque les bobines 201, 211 et 221 sont alignées entre elles et que leurs axes longitudinaux respectifs sont confondus, ces bobines 201, 211 et 221 peuvent partager une même carcasse commune. Plus précisément, les enroulements respectifs de ces bobines 201, 211 et 221 sont ménagés autour d'une même carcasse. Cela permet d'augmenter encore la compacité de l'appareil 2. Il en va de même pour les bobines 203, 213 et 223.

En variante, l'appareil 2 comporte un nombre différent de capteurs. Par exemple, l'appareil 2 comporte uniquement les capteurs 20 et 21, de sorte que le capteur 22 est omis. Ceci est par exemple utile lorsqu'on veut mesurer le courant uniquement dans deux conducteurs électriques, par exemple dans un système électrique ou l'un des conducteurs est une phase et l'autre des conducteurs est un neutre associé à cette phase.

Selon une autre variante, toutes les bobines sont identiques entre elles.

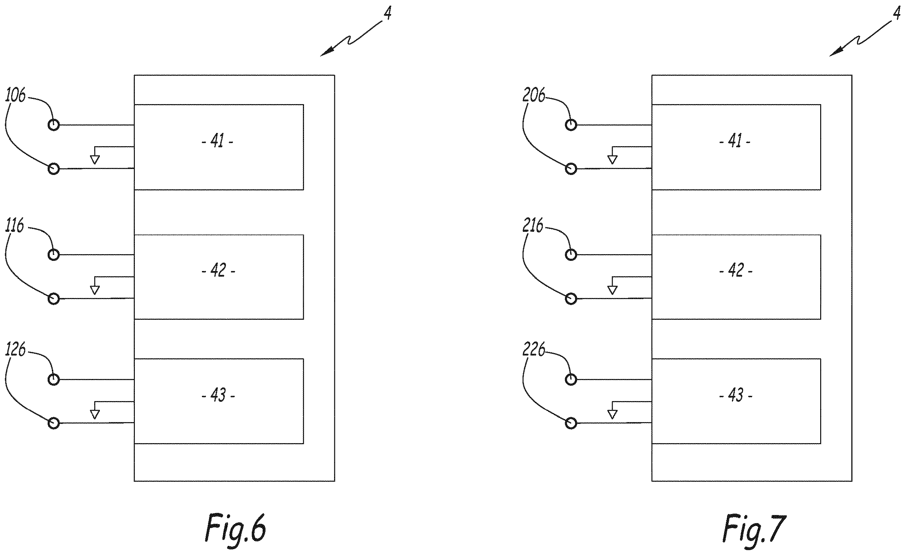

La figure 6 illustre schématiquement l'unité de traitement de données 4 connectée aux bornes 106, 116, 126 des capteurs 10, 11 et 12 de l'ensemble 1. Plus précisément, l'unité de traitement de données 4 comporte trois circuits de mesure différentielle, notés 41, 42 et 43. Les circuits 41, 42 et 43 sont connectés, respectivement, aux bornes 106, 116 et 126 et à la masse électrique commune.

La figure 7 illustre la même unité de traitement 4, cette fois connectée aux bornes de mesure 206, 216 et 226 des capteurs 20, 21 et 22 de l'ensemble de mesure 2. Plus précisément, les circuits 41, 42 et 43 sont connectés, respectivement, aux bornes 206, 216 et 226 ainsi qu'à la masse électrique commune. Ainsi, la même unité de traitement de données 4 peut être réutilisée telle quelle pour être utilisée avec l'ensemble de mesure 2 sans qu'il ne soit nécessaire de transformer les circuits 41, 42 et 43.

Les modes de réalisation et les variantes envisagés ci-dessus peuvent être combinés entre eux pour générer de nouveaux modes de réalisation, dans les limites des revendications annexées.

## Revendications

1. Appareil de mesure (2) de courants électriques, comprenant des premier et deuxième capteurs (20, 21) de courants de type Rogowski, chacun apte à mesurer un courant électrique alternatif dans des premier et deuxième conducteurs électriques (200, 210), chacun des premier et deuxième capteurs comportant des bobines (201, 202, 203, 204, 211, 213, 214) raccordées électriquement en série pour former, respectivement, des premier et deuxième circuits de mesure, chaque bobine s'étendant selon un axe longitudinal (X201, X202, X203, X204, X211, X213, X214), les bobines d'un même capteur étant accolées entre elles de sorte à délimiter une zone centrale (205, 215) de ce capteur (20, 21) pour recevoir le conducteur électrique correspondant (200, 210), les bobines d'un même capteur ayant leurs axes longitudinaux formant un contour polygonal fermé (C20, C21) entourant cette zone centrale de ce capteur, l'une des bobines (204) étant commune aux premier et deuxième capteurs (20, 21), cette bobine (204) étant raccordée électriquement aux premier et deuxième circuits de mesure, l'axe longitudinal (X204) de cette bobine appartenant aux premier et deuxième contours polygonaux (C20, C21), l'appareil de mesure (2) étant **caractérisé en ce que** le contour polygonal (C20, C21) est un contour polygonal fermé.

2. Appareil selon la revendication 1, **caractérisé en ce qu'**il comporte en outre un troisième capteur de courant de type Rogowski apte à mesurer un courant électrique dans un troisième conducteur électrique (220) ce troisième capteur comportant des bobines (214, 221, 223, 224) raccordées électriquement en série pour former un quatrième circuit de mesure, ces bobines étant accolées entre elles de sorte à délimiter une zone centrale (225) du troisième capteur pour recevoir le troisième conducteur électrique (220), les axes longitudinaux (X214, X221, X223, X224) respectifs de ces bobines formant un troisième contour polygonal fermé (C22) qui entoure la zone centrale de ce capteur, l'une des bobines (214) est commune aux deuxième et troisième capteurs (22), cette bobine (214) étant raccordée électriquement aux deuxième et troisième circuits de mesure, l'axe longitudinal (X214) de cette bobine appartenant aux deuxième et troisième contours polygonaux (C22).

3. Appareil selon l'une des revendications précédentes, **caractérisé en ce que** les circuits de mesure des capteurs (20, 21, 22) sont raccordés à une masse électrique commune (23) de l'appareil de mesure (2).

4. Appareil selon l'une des revendications précédentes, **caractérisé en ce qu'**il comporte un support (3), sur lequel les bobines (201, 202, 203, 204, 211, 213, 214, 221, 223, 224) sont fixées et étant pourvu de pistes (31) électriquement conductrices, les bobines étant raccordées électriquement entre elles au moyen des pistes (31) pour former les circuits de mesure.

5. Appareil selon l'une des revendications précédentes, **caractérisé en ce que** les contours polygonaux (C20, C21, C22) présentent une forme de quadrilatère, par exemple une forme carrée.

6. Appareil selon la revendication 5, **caractérisé en ce que** chaque capteur (20, 21, 22) comporte quatre bobines, l'axe longitudinal (X201, X202, X203, X204) de chaque bobine de ce capteur formant un côté du quadrilatère.

7. Appareil selon l'une des revendications précédentes, **caractérisé en ce que** les contours polygonaux (C20, C21, C22) sont contenus dans un même plan géométrique essentiellement perpendiculaire aux conducteurs électriques (200, 210, 220).

8. Appareil selon la revendication 7, **caractérisé en ce que** chaque bobine (201, 202, 203, 204, 211, 213, 214, 221, 223, 224) comporte un enroulement ménagé autour d'une carcasse s'étendant le long de l'axe longitudinal de la bobine, au moins deux bobines (201, 211, 221 ; 203 ; 213 ; 223) de capteurs distincts et dont les axes longitudinaux sont confondus entre eux partagent une même carcasse s'étendant le long de cet axe, les enroulements respectifs de ces bobines étant ménagés autour de cette même carcasse.

9. Appareil selon l'une des revendications précédentes, **caractérisé en ce qu'**au moins une bobine (201, 203, 211, 213, 221, 213) comporte une zone d'extrémité (250) dans laquelle l'inductance de la bobine est augmentée par rapport au reste de la bobine.

10. Appareil selon l'une des revendications précédentes, **caractérisé en ce que** les bobines (201, 202, 203, 204, 211, 213, 214, 221, 223, 224) de chaque capteur (20, 21, 22) sont arrangées et connectées entre elles de sorte à présenter des sens de bobinage complémentaires, c'est-à-dire arrangés de sorte à tourner dans un même sens autour du conducteur électrique (200, 210, 220) autour duquel le capteur correspondant est placé.

## Patentansprüche

1. Messgerät (2) für elektrische Ströme, umfassend einen ersten und einen zweiten Rogowski-Stromsensor (20, 21), die jeweils geeignet sind, um einen elektrischen Wechselstrom in einem ersten und einem zweiten elektrischen Leiter (200, 210) zu messen, jeder von dem ersten und dem zweiten Sensor umfassend Spulen (201, 202, 203, 204, 211, 213, 214), die elektrisch in Reihe geschaltet sind, um jeweils einen ersten und einen zweiten Messkreis zu bilden, wobei sich jede Spule entlang einer Längsachse (X201, X202, X203, X204, X211, X213, X214) erstreckt, wobei die Spulen ein und desselben Sensors aneinandergefügt sind, um einen mittleren Bereich (205, 215) dieses Sensors (20, 21) zum Aufnehmen des entsprechenden elektrischen Leiters (200, 210) zu bilden, wobei die Spulen desselben Sensors mit ihren Längsachsen einen geschlossenen polygonalen Kontur (C20, C21) bilden, der diesen mittleren Bereich dieses Sensors umgibt, wobei eine der Spulen (204) dem ersten und dem zweiten Sensor (20, 21) gemeinsam ist, wobei diese Spule (204) elektrisch mit dem ersten und dem zweiten Messkreis verbunden ist, wobei die Längsachse (X204) dieser Spule zu der ersten und der zweiten polygonalen Kontur (C20, C21) gehört, wobei das Messgerät (2) **dadurch gekennzeichnet ist, dass** die polygonale Kontur (C20, C21) eine geschlossene polygonale Kontur ist.

2. Gerät nach Anspruch 1, **dadurch gekennzeichnet, dass** es ferner einen dritten Rogowski-Stromsensor umfasst, der geeignet ist, um einen elektrischen Strom in einem dritten elektrischen Leiter (220) zu messen, dieser dritte Sensor umfassend Spulen (214, 221, 223, 224), die elektrisch in Reihe geschaltet sind, um einen vierten Messkreis zu bilden, wobei diese Spulen aneinandergefügt sind, um einen mittleren Bereich (225) des dritten Sensors zu begrenzen, um den dritten elektrischen Leiter (220) aufzunehmen, wobei die jeweiligen Längsachsen (X214, X221, X223, X224) dieser Spulen eine dritte geschlossene polygonale Kontur (C22) bilden, die den mittleren Bereich dieses Sensors umgibt, eine der Spulen (214) dem zweiten und dem dritten Sensor (22) gemeinsam ist, diese Spule (214) elektrisch mit dem zweiten und dem dritten Messkreis verbunden ist und die Längsachse (X214) dieser Spule zu der zweiten und der dritten polygonalen Kontur (C22) gehört.

3. Gerät nach einem der vorherigen Ansprüche, **dadurch gekennzeichnet, dass** die Messkreise der Sensoren (20, 21, 22) mit einer gemeinsamen elektrischen Masse (23) des Messgeräts (2) verbunden sind.

4. Gerät nach einem der vorherigen Ansprüche, **dadurch gekennzeichnet, dass** es einen Träger (3) umfasst, an dem die Spulen (201, 202, 203, 204, 211, 213, 214, 221, 223, 224) befestigt sind und der mit elektrisch leitenden Bahnen (31) versehen ist, wobei die Spulen mittels der Bahnen (31) elektrisch miteinander verbunden sind, um die Messkreise zu bilden.

5. Vorrichtung nach einem der vorherigen Ansprüche, **dadurch gekennzeichnet, dass** die polygonalen Konturen (C20, C21, C22) eine viereckige Form aufweisen, z. B. eine quadratische Form.

6. Gerät nach Anspruch 5, **dadurch gekennzeichnet, dass** jeder Sensor (20, 21, 22) vier Spulen aufweist, wobei die Längsachse (X201, X202, X203, X204) von jeder Spule dieses Sensors eine Seite des Vierecks bildet.

7. Gerät nach einem der vorherigen Ansprüche, **dadurch gekennzeichnet, dass** die polygonalen Konturen (C20, C21, C22) in einer gleichen geometrischen Ebene enthalten sind, die im Wesentlichen senkrecht zu den elektrischen Leitern (200, 210, 220) ist.

8. Gerät nach Anspruch 7, **dadurch gekennzeichnet, dass** jede Spule (201, 202, 203, 204, 211, 213, 214, 221, 223, 224) eine Wicklung aufweist, die um ein Gehäuse angeordnet ist, das sich entlang der Längsachse der Spule erstreckt, wobei mindestens zwei Spulen (201, 211, 221; 203; 213; 223) mit unterschiedlichen Sensoren, deren Längsachsen miteinander zusammenfallen, ein gemeinsames Gehäuse aufweisen, das sich entlang dieser Achse erstreckt, wobei die jeweiligen Wicklungen dieser Spulen um das gleiche Gehäuse angeordnet sind.

9. Gerät nach einem der vorherigen Ansprüche, **dadurch gekennzeichnet, dass** mindestens eine Spule (201, 203, 211, 213, 221, 213) einen Endbereich (250) aufweist, in dem die Induktivität der Spule im Vergleich zum Rest der Spule erhöht ist.

10. Gerät nach einem der vorherigen Ansprüche, **dadurch gekennzeichnet, dass** die Spulen (201, 202, 203, 204, 211, 213, 214, 221, 223, 224) von jedem Sensor (20, 21, 22) angeordnet und untereinander verbunden sind, um komplementäre Wicklungsrichtungen aufzuweisen, d. h. angeordnet sind, um sich in der gleichen Richtung um den elektrischen Leiter (200, 210, 220) zu drehen, um den der jeweilige Sensor angeordnet ist.

## Claims

1. An electric current measuring apparatus (2) comprising first and second Rogowski current sensors (20, 21) each adapted to measure an alternating electric current in first and second electrical conductors (200, 210), each of the first and second sensors comprising coils (201, 202, 203, 204, 211, 213, 214) electrically connected in series to form, respectively, first and second measuring circuits, each coil extending along a longitudinal axis (X201, X202, X203, X204, X211, X213, X214), the coils of a given sensor being adjoined to each other so as to delimit a central zone (205, 215) of that sensor (20, 21) to receive the corresponding electrical conductor (200, 210), the coils of a given sensor having their longitudinal axes forming a closed polygonal contour (C20, C21) surrounding this central zone of this sensor, one of the coils (204) being common to the first and second sensors (20, 21), that coil (204) being electrically connected to the first and second measuring circuits, the longitudinal axis (X204) of that coil belonging to the first and second polygonal contours (C20, C21), the measuring apparatus (2) being **characterised in that** the polygonal contour (C20, C21) is a closed polygonal contour.

2. The apparatus according to claim 1, **characterised in that** it further comprises a third Rogowski current sensor capable of measuring an electric current in a third electrical conductor (220), this third sensor comprising coils (214, 221, 223, 224) electrically connected in series to form a fourth measuring circuit, these coils being joined together so as to delimit a central zone (225) of the third sensor for receiving the third electrical conductor (220), the respective longitudinal axes (X214, X221, X223, X224) of these coils forming a third closed polygonal contour (C22) which surrounds the central zone of this sensor, one of the coils (214) is common to the second and third sensors (22), this coil (214) being electrically connected to the second and third measuring circuits, the longitudinal axis (X214) of this coil belonging to the second and third polygonal contours (C22).

3. The apparatus according to one of the preceding claims, **characterised in that** the measuring circuits of the sensors (20, 21, 22) are connected to a common electrical ground (23) of the measuring apparatus (2).

4. The apparatus according to one of the preceding claims, **characterised in that** it comprises a support (3), to which the coils (201, 202, 203, 204, 211, 213, 214, 221, 223, 224) are fixed and which is provided with electrically conductive tracks (31), the coils being electrically connected to each other by means of the tracks (31) to form the measuring circuits.

5. The apparatus according to any of the preceding claims, **characterised in that** the polygonal contours (C20, C21, C22) have a quadrilateral shape, for example a square shape.

6. The apparatus according to claim 5, **characterised in that** each sensor (20, 21, 22) comprises four coils, the longitudinal axis (X201, X202, X203, X204) of each coil of that sensor forming one side of the quadrilateral.

7. The apparatus according to any of the preceding claims, **characterised in that** the polygonal contours (C20, C21, C22) are contained in a single geometric plane substantially perpendicular to the electrical conductors (200, 210, 220).

8. The apparatus according to claim 7, **characterised in that** each coil (201, 202, 203, 204, 211, 213, 214, 221, 223, 224) comprises a winding formed around a frame extending along the longitudinal axis of the coil, at least two coils (201, 211, 221; 203; 213; 223) of distinct sensors, the longitudinal axes of which are coincident with each other, share the same frame extending along this axis, the respective windings of these coils being formed around this same frame.

9. The apparatus according to any of the preceding claims, **characterised in that** at least one coil (201, 203, 211, 213, 221, 213) has an end region (250) in which the inductance of the coil is increased relative to the rest of the coil.

10. The apparatus according to any of the preceding claims, **characterised in that** the coils (201, 202, 203, 204, 211, 213, 214, 221, 223, 224) of each sensor (20, 21, 22) are arranged and connected to each other so as to have complementary winding directions, i.e. arranged so as to rotate in the same direction around the electrical conductor (200, 210, 220) around which the corresponding sensor is placed.
